# EUROPEAN PATENT SPECIFICATION

(11) **EP 4 191 591 B1**
(45) Date of publication and mention of the grant of the patent: **28.01.2026**
(21) Application number: 20949061.4
(22) Date of filing: 13.08.2020
(51) Int. Cl.: G11C 11/16, H10B 61/00

(54) **STORAGE UNIT AND RELATED DEVICE**
SPEICHEREINHEIT UND ZUGEHÖRIGE VORRICHTUNG
UNITÉ DE STOCKAGE ET DISPOSITIF ASSOCIÉ

(43) Date of publication of application: 07.06.2023
(73) Proprietor: Huawei Technologies Co., Ltd., Shenzhen, Guangdong 518129 (CN)
(72) Inventor: QIN, Qing, Shenzhen, Guangdong 518129 (CN); ZHOU, Xue, Shenzhen, Guangdong 518129 (CN)
(74) Representative: Gill Jennings & Every LLP
(86) International application number: PCT/CN2020/108844
(87) International publication number: WO 2022/032562

(56) References cited:
- CN-A- 103 295 630
- CN-A- 110 277 115
- CN-A- 110 277 490
- CN-A- 110 323 247
- CN-A- 110 910 924
- JP-A- 2009 295 775
- US-A- 5 978 257
- US-A- 5 978 257
- US-A1- 2013 208 523
- US-A1- 2014 273 284
- US-B2- 9 047 964

## Description

### TECHNICAL FIELD

Embodiments of this application relate to the communications field, and in particular, to a storage unit and a related device.

### BACKGROUND

A memory is an important part of a computer system structure, and has a decisive impact on a speed, integration, power consumption, and the like of a computer.

A magnetoresistive random access memory (magnetic random access memory, MRAM) is a new nonvolatile memory technology, and gradually gains attention from a person in the art because of a high speed, low power consumption, and good complementary metal-oxide-semiconductor (Complementary Metal Oxide Semiconductor, CMOS) compatibility. The MRAM has a high-speed read/write capability of a static random access memory and a high integration degree of a dynamic random access memory, and is a high-quality storage apparatus. Unlike mainstream storage, the MRAM stores information by using a change of a magnetic polarization direction.

In an existing MRAM storage technology, the MRAM can only record two states: 0 and 1 by using a difference of high resistance and low resistance of a magnetic tunnel junction (magnetic tunneling junction, MTJ). A data storage capacity is limited.

JP 2009 295775 A discloses a magnetic storage element wherein the magnetization direction is inverted by spin-polarized electrons, including: a first unit magnetic storage element including a laminate structure of a first pin layer, a first tunnel insulating layer, and a first free layer; a second unit magnetic storage element including a laminate structure of a second pin layer, a second tunnel insulating layer, and a second free layer; and a connection electrode which electrically connects the first pin layer and the second pin layer to connect the first unit magnetic storage element and the second unit magnetic storage element in series. A cross-section area of the second unit magnetic storage element in a direction perpendicular to an electron movement direction is larger than that of the first unit magnetic storage element.

US2013/208523 A1 discloses a self-referenced magnetic random access memory-based ternary content addressable memory (MRAM-based TCAM) cell comprising a first and second magnetic tunnel junction.

US9047964 B2 discloses a Multi-Level Memory Cell (MLC) using multiple Magnetic Tunnel Junction (MTJ) structures having one or more layers with varying thickness. The multiple MTJ structures, which are vertically stacked and arranged in series, may have substantially identical area dimensions to minimize fabrication costs because one mask can be used to pattern the multiple MTJ structures.

### SUMMARY

Embodiments of this application provide a storage unit and a related device. Currents with different directions and different magnitudes flow through a first MTJ and a second MTJ, thereby changing a resistance status of the first MTJ and/or the second MTJ. In this way, polymorphic storage may be implemented by using a combination of different resistance values of the first MTJ and the second MTJ, thereby improving storage efficiency of a memory.

A first aspect of the embodiments of this application provides a storage unit according to appended claim 1.

A second aspect of the embodiments of this application provides a storage unit according to appended claim 2.

The embodiments of this application provide the storage unit. The first electrode of the first MTJ included in the storage unit is connected in series to the first electrode of the second MTJ by using the first metallic wire. The first electrode of the first MTJ and the first electrode of the second MTJ are electrodes of the same layer. In other words, the first electrode of the first MTJ and the second electrode of the second MTJ are both top electrodes or bottom electrodes. Currents with different directions and different magnitudes flow through the first MTJ and the second MTJ, thereby changing a resistance status of the first MTJ and/or the second MTJ. The electrodes of the same layer of the first MTJ and the second MTJ are connected. A direction from the bottom electrode to the top electrode of the first MTJ and the second MTJ is used as a reference direction. A current in the first MTJ and a current in the second MTJ have the same magnitude and opposite directions. An effect of the current on a magnetic field direction of a free layer of the first MTJ and an effect of the current on a magnetic field direction of a free layer of the second MTJ are opposite. Further, polymorphic storage may be implemented by using a combination of different resistance values of the first MTJ and the second MTJ, thereby improving storage efficiency of a memory.

In a possible implementation of the first aspect, the first MTJ and the second MTJ are located at the same layer of a laminated structure and are formed through one time of thin film deposition. A thickness of the first MTJ is the same as a thickness of the second MTJ. Critical dimensions of the first MTJ are different from those of the second MTJ. Therefore, resistance values of the first MTJ and the second MTJ are different, to implement polymorphic storage. The first MTJ and the second MTJ are formed through one time of thin film deposition, to reduce processes of processing the first MTJ and the second MTJ, thereby reducing the costs of manufacturing the first MTJ and the second MTJ.

In the first aspect, the storage unit includes a third MTJ, the first metallic wire, a second metallic wire, a first metal connection piece, a second metal connection piece, and a switching element. A second electrode of the first MTJ is electrically connected to a first end of the switching element by using the first metal connection piece. The second MTJ is connected in series to the third MTJ by using the second metallic wire. A first end of the second metallic wire is electrically connected to a second electrode of the second MTJ. A second end of the second metallic wire is electrically connected to a first electrode of the third MTJ. The second electrode of the second MTJ and the first electrode of the third MTJ are both top electrodes or bottom electrodes. A second electrode of the third MTJ is electrically connected to a bit line by using the second metal connection piece. A second end of the switching element is electrically connected to a source line. A control end of the switching element is electrically connected to a word line.

In this possible implementation, the storage unit further includes the third MTJ. Resistance statuses of the storage unit are improved from four resistance statuses corresponding to two MTJs to eight resistance statuses corresponding to three MTJs, thereby improving storage efficiency of the storage unit.

In the first aspect, an included angle between the first metallic wire and the second metallic wire is an acute angle. Connection lines between a center of the first MTJ, a center of the second MTJ, and a center of the third MTJ form an acute triangle.

In this aspect, the center of the first MTJ, the center of the second MTJ, and the center of the third MTJ are arranged in a triangle manner. Further, space occupied when the three MTJs are arranged can be reduced, and a volume of the memory can be further reduced.

In the second aspect, the storage unit includes a second metallic wire, a third metallic wire, a third MTJ, a fourth MTJ, a first metal connection piece, a second metal connection piece, and a switching element. A second electrode of the first MTJ is electrically connected to a first end of the switching element by using the first metal connection piece. The second MTJ is connected in series to the third MTJ by using the second metallic wire. A first end of the second metallic wire is electrically connected to a second electrode of the second MTJ. A second end of the second metallic wire is electrically connected to a first electrode of the third MTJ. The second electrode of the second MTJ and the first electrode of the third MTJ are both top electrodes or bottom electrodes. The third MTJ is connected in series to the fourth MTJ by using the third metallic wire. A first end of the third metallic wire is electrically connected to a second electrode of the third MTJ. A second end of the third metallic wire is electrically connected to a first electrode of the fourth MTJ. The second electrode of the third MTJ and the first electrode of the fourth MTJ are both top electrodes or bottom electrodes. A second end of the switching element is electrically connected to a source line. A control end of the switching element is electrically connected to a word line.

In the second aspect, the storage unit further includes the third MTJ and the fourth MTJ. Resistance statuses of the storage unit are improved from four resistance statuses corresponding to two MTJs to 16 resistance statuses corresponding to four MTJs, thereby improving storage efficiency of the storage unit.

In the second aspect, connection lines between a center of the first MTJ, a center of the second MTJ, a center of the third MTJ, and a center of the fourth MTJ form a quadrangle.

In the second aspect, the first MTJ, the second MTJ, the third MTJ, and the fourth MTJ are arranged in a quadrangle manner. Further, space occupied when the four MTJs are arranged can be reduced, and a volume of the memory can be further reduced.

In a possible implementation of the first aspect or the second aspect, the bit line is parallel with the first metallic wire, the bit line is perpendicular to the word line, and the bit line is perpendicular to the source line.

In this possible implementation, an arrangement manner of possible implementation of the bit line (bit line), the word line (word line), and the source line (source line) is provided. The bit line is parallel with the first metallic wire. The bit line is perpendicular to the word line. The bit line is perpendicular to the source line. Space occupied when the bit line, the word line, and the source line are arranged can be reduced, and a volume of the memory can be further reduced.

In a possible implementation of the first aspect or the second aspect, the bit line is perpendicular to the first metallic wire, the bit line is perpendicular to the word line, and the bit line is parallel with the source line.

In this possible implementation, an arrangement manner of possible implementation of the bit line, the word line, and the source line is provided. The bit line is perpendicular to the first metallic wire. The bit line is perpendicular to the word line. The bit line is parallel with the source line. Space occupied when the bit line, the word line, and the source line are arranged can be reduced, and a volume of the memory can be further reduced.

A third aspect of the embodiments of this application provides a storage array. The storage array includes a word line, a bit line, a source line, and at least one storage unit. The storage unit is the storage unit described in the first aspect or any possible implementation of the first aspect, or the second aspect or any possible implementation of the second aspect.

A fourth aspect of the embodiments of this application provides a memory. The memory includes a storage unit and a controller.

The storage unit stores data under control of the controller. The storage unit is the storage unit described in the first aspect or any possible implementation of the first aspect, or the second aspect or any possible implementation of the second aspect.

A fifth aspect of the embodiments of this application provides a computing memory. The computing memory includes a storage unit and a controller.

The storage unit stores data and/or calculates data under control of the controller. The storage unit is the storage unit described in the first aspect or any possible implementation of the first aspect, or the second aspect or any possible implementation of the second aspect.

### BRIEF DESCRIPTION OF DRAWINGS

FIG. 1a is a schematic diagram of a structure of an MTJ suitable for use in embodiments of this application;
FIG. 1b is a schematic diagram of a structure of a memory according to an embodiment of this application;
FIG. 2 is a schematic diagram of a structure of a storage unit not forming part of the invention;
FIG. 3 is a schematic diagram of another structure of a storage unit according to an example not forming part of the invention;
FIG. 4 is a schematic diagram of an example of a storage unit not forming part of the invention;
FIG. 5 is a schematic diagram of another example of a storage unit not forming part of the invention;
FIG. 6 is a schematic diagram of another example of a storage unit not forming part of the invention;
FIG. 7 is a schematic diagram of another example of a storage unit not forming part of the invention;
FIG. 8 is a schematic diagram of another example of a storage unit not forming part of the invention;
FIG. 9 is a schematic diagram of another example of a storage unit not forming part of the invention;
FIG. 10 is a schematic diagram of another example of a storage unit not forming part of the invention;
FIG. 11 is a schematic diagram of another example of a storage unit example not forming part of the invention;
FIG. 12 is a schematic diagram of another embodiment of a storage unit according to an embodiment of this application;
FIG. 13 is a schematic diagram of another embodiment of a storage unit according to an embodiment of this application;
FIG. 14 is a schematic diagram of another example of a storage unit not forming part of the invention;
FIG. 15 is a schematic diagram of another embodiment of a storage unit according to an embodiment of this application;
FIG. 16 is a schematic diagram of another example of a storage unit not forming part of the invention; and
FIG. 17 is a schematic diagram of another example of a storage unit not forming part of the invention.

### DESCRIPTION OF EMBODIMENTS

To make the objectives, technical solutions, and advantages of this application clearer, the following describes the embodiments of this application with reference to the accompanying drawings. Apparently, the described embodiments are merely some rather than all of the embodiments of this application. A person of ordinary skill in the art may know that, with development of emergence of a new application scenario, the technical solutions provided in the embodiments of this application are also applicable to a similar technical problem.

In the specification, claims, and accompanying drawings of this application, the terms "first", "second", and so on are intended to distinguish between similar objects but do not necessarily indicate a specific order or sequence. It should be understood that the data used in such a way are interchangeable in appropriate circumstances, so that embodiments described herein can be implemented in an order other than the content illustrated or described herein. Moreover, terms "include", "contain", and any other variant thereof are intended to cover non-exclusive inclusion. For example, a process, a method, a system, a product, or a device that includes a list of steps or modules is not necessarily limited to those expressly listed steps or modules, but may include other steps or modules not expressly listed or inherent to the process, the method, the product, or the device. Names or numbers of steps in this application do not mean that the steps in the method procedure need to be performed in a time/logical sequence indicated by the names or numbers. An execution sequence of the steps in the procedure that have been named or numbered can be changed based on a technical objective to be achieved, provided that same or similar technical effects can be achieved.

The term "and/or" in this application describes only an association relationship for describing associated objects and represents that three relationships may exist. For example, A and/or B may represent the following three cases: Only A exists, both A and B exist, and only B exists. Herein, A/B may be singular or plural. In addition, in the descriptions of this application, "a plurality of" means two or more than two unless otherwise specified. "At least one of the following items (pieces)" or a similar expression thereof refers to any combination of these items, including any combination of singular items (pieces) or plural items (pieces). For example, at least one of a, b, or c may indicate: a, b, c, a and b, a and c, b and c, or a, b, and c, where a, b, and c may be singular or plural.

A memory is an important part of a computer system structure, and has a decisive impact on a speed, integration, power consumption, and the like of a computer.

A magnetoresistive random access memory (magnetic random access memory, MRAM) is a new nonvolatile memory technology, and gradually gains attention from a person in the art because of a high speed, low power consumption, and good complementary metal-oxide-semiconductor (Complementary Metal Oxide Semiconductor, CMOS) compatibility. The MRAM has a high-speed read/write capability of a static random access memory and a high integration degree of a dynamic random access memory, and is a high-quality storage apparatus. Unlike mainstream storage, the MRAM stores information by using a change of a magnetic polarization direction.

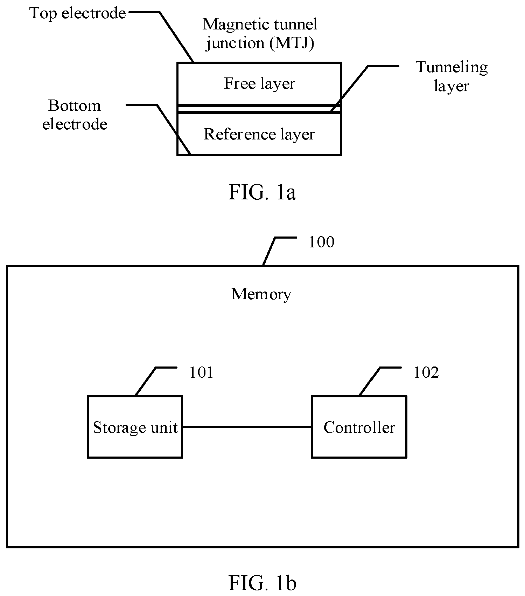

FIG. 1a is a schematic diagram of a structure of an MTJ suitable for use in embodiments of this application.

As shown in FIG. 1a, a module used for storage in the MRAM includes a magnetic tunnel junction (magnetic tunneling junction, MTJ). The MTJ mainly includes a free layer for storing information, a tunneling layer, and a reference layer for fixing a magnetization direction. Magnetism of the reference layer remains unchanged. Magnetism of the free layer changes with a change of a control current or another magnetic overturn mechanism. A magnetic field direction in the reference layer is preset. The magnetic field direction in the reference layer may be upward, or the magnetic field direction in the reference layer may be downward. This is not specifically limited herein. When a magnetization direction of the reference layer is parallel with a magnetization direction of the free layer, the storage unit presents low resistance. When a magnetization direction of the reference layer is not parallel with a magnetization direction of the free layer, the storage unit presents high resistance. A resistance value of the MTJ can be changed based on currents with different directions and different magnitudes. Due to this feature, data can be recorded as 0 or 1 through a circuit design. The MTJ further includes a top electrode and a bottom electrode. The top electrode and the bottom electrode have different structures. Optionally, etching processes of the top electrode and the bottom electrode may be different. Optionally, shapes of the top electrode and the bottom electrode may be different. This is not specifically limited herein. Optionally, a direction of the free layer and the reference layer shown in the figure may be that the free layer is above the reference layer and the free layer is relatively close to the top electrode, or may be that the free layer is below the reference layer and the free layer is relatively close to the bottom electrode. This is not specifically limited herein.

In an existing MRAM storage technology, the MRAM can only record two states: 0 and 1 by using a difference of high resistance and low resistance of an MTJ. A data storage capacity is limited.

For the foregoing problems existing in the existing memory, an example not forming part of the invention provides a storage unit. The storage unit provided in this example includes a first magnetic tunnel junction MTJ, a second MTJ, and a first metallic wire. The first MTJ and the second MTJ are formed through one time of thin film deposition. The first MTJ and the second MTJ have different dimensions. A first electrode of the first MTJ is connected in series to a first electrode of the second MTJ by using the first metallic wire. The first electrode of the first MTJ and the first electrode of the second MTJ are electrodes of the same layer. Currents with different directions and different magnitudes flow through the first MTJ and the second MTJ, thereby changing a resistance status of the first MTJ and/or the second MTJ. In this way, polymorphic storage may be implemented by using a combination of different resistance values of the first MTJ and the second MTJ, thereby improving storage efficiency of a memory.

The following clearly and completely describes the technical solutions in this application with reference to the accompanying drawings in this application. It is clear that the described embodiments are merely some but not all of the embodiments of this application. The following specific embodiments may be combined with each other, and same or similar content is not repeatedly described in different embodiments. It should be further noted that lengths, widths, and heights (or thicknesses) of components shown in the embodiments of this application are merely example descriptions, instead of limiting the storage unit in this application.

FIG. 1b is a schematic diagram of a structure of a memory according to an embodiment of this application.

With reference to FIG. 1b, the memory 100 provided in this embodiment of this application includes a storage unit 101 and a controller 102. The storage unit 101 included in the memory may be one storage unit, or the storage unit 101 may be a plurality of storage units. This is not specifically limited herein.

The storage unit 101 is electrically connected to the controller 102. The storage unit 101 is a component configured to store data in an electronic device integrated with the memory. The storage unit 101 receives one or more control signals generated by the controller 102. The storage unit 101 stores data based on the one or more control signals.

In this embodiment of this application, the memory may include one storage unit, or the memory may include two or more storage units. This is not specifically limited herein.

The storage unit provided in this embodiment of this application is described based on the schematic diagrams of structures of the memories described in FIG. 1a and FIG. 1b.

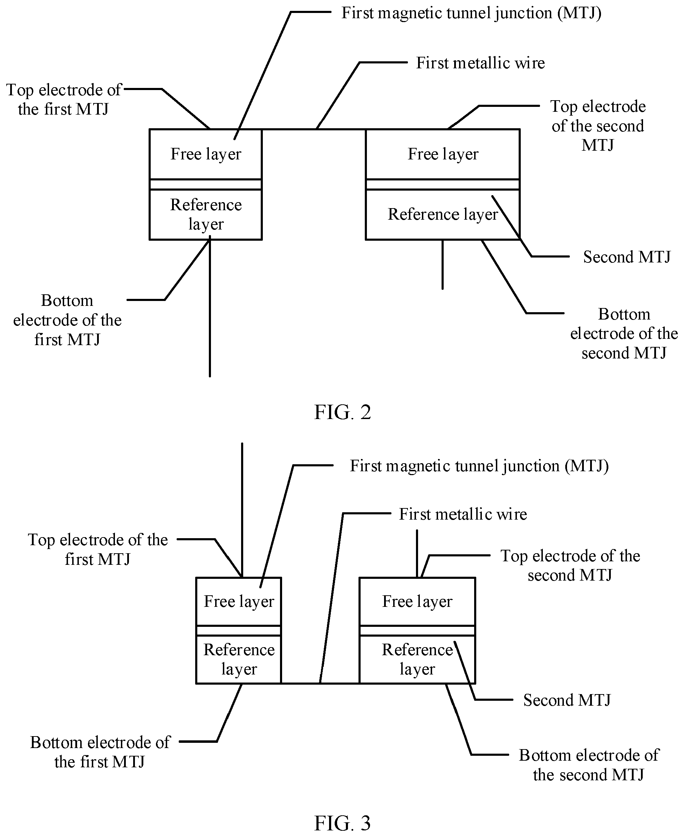

FIG. 2 is a schematic diagram of a structure of a storage unit according to an example not forming part of the invention.

With reference to FIG. 2, an example provides a storage unit. The storage unit includes a first magnetic tunnel junction MTJ, a second MTJ, and a first metallic wire. The first MTJ and the second MTJ are located at the same layer of a film layer structure, and are formed through one time of thin film deposition. The first MTJ and the second MTJ have different dimensions.

A first electrode of the first MTJ is connected in series to a first electrode of the second MTJ by using the first metallic wire. The first electrode of the first MTJ and the first electrode of the second MTJ are electrodes of the same layer.

A first end of the first metallic wire is electrically connected to the first electrode of the first MTJ. A second end of the first metallic wire is electrically connected to the first electrode of the second MTJ.

Currents with different directions and different magnitudes flow through the first MTJ and the second MTJ, thereby changing a resistance status of the first MTJ and/or the second MTJ. In other words, currents with different directions and different magnitudes flow through the first MTJ and the second MTJ, thereby changing the resistance status of the first MTJ, or changing the resistance status of the second MTJ, and/or changing the resistance statuses of the first MTJ and the second MTJ. This is not specifically limited herein.

In this example, that the first MTJ is less than the second MTJ shown in FIG. 2 is merely used as an example for description. In an actual application process, the first MTJ may be less than the second MTJ, or the second MTJ may be less than the first MTJ. This is not specifically limited herein.

FIG. 3 is a schematic diagram of a structure of another storage unit according to an example not forming part of the invention.

A first electrode of the first MTJ is connected in series to a first electrode of the second MTJ by using the first metallic wire. The first electrode of the first MTJ and the first electrode of the second MTJ are electrodes of the same layer.

In this example, that the first electrode of the first MTJ and the first electrode of the second MTJ are the electrodes of the same layer may be used to indicate that the first electrode of the first MTJ and the first electrode of the second MTJ are both top electrodes, or the first electrode of the first MTJ and the first electrode of the second MTJ are both bottom electrodes. A structure of the storage unit provided in this example may be the structure shown in FIG. 2, or may be the structure shown in FIG. 3. This is not specifically limited herein. As shown in FIG. 2, if the first electrode of the first MTJ and the first electrode of the second MTJ are both top electrodes, the top electrode of the first MTJ is connected in series to the top electrode of the second MTJ by using the first metallic wire. As shown in FIG. 3, if the first electrode of the first MTJ and the first electrode of the second MTJ are both bottom electrodes, the bottom electrode of the first MTJ is connected in series to the bottom electrode of the second MTJ by using the first metallic wire.

The first MTJ and the second MTJ are located at the same film layer structure. The first MTJ and the second MTJ are formed through one time of thin film deposition. The first MTJ and the second MTJ have different dimensions.

In this example, that the first MTJ is less than the second MTJ shown in FIG. 3 is merely used as an example for description. In an actual application process, the first MTJ may be less than the second MTJ, or the second MTJ may be less than the first MTJ. This is not specifically limited herein.

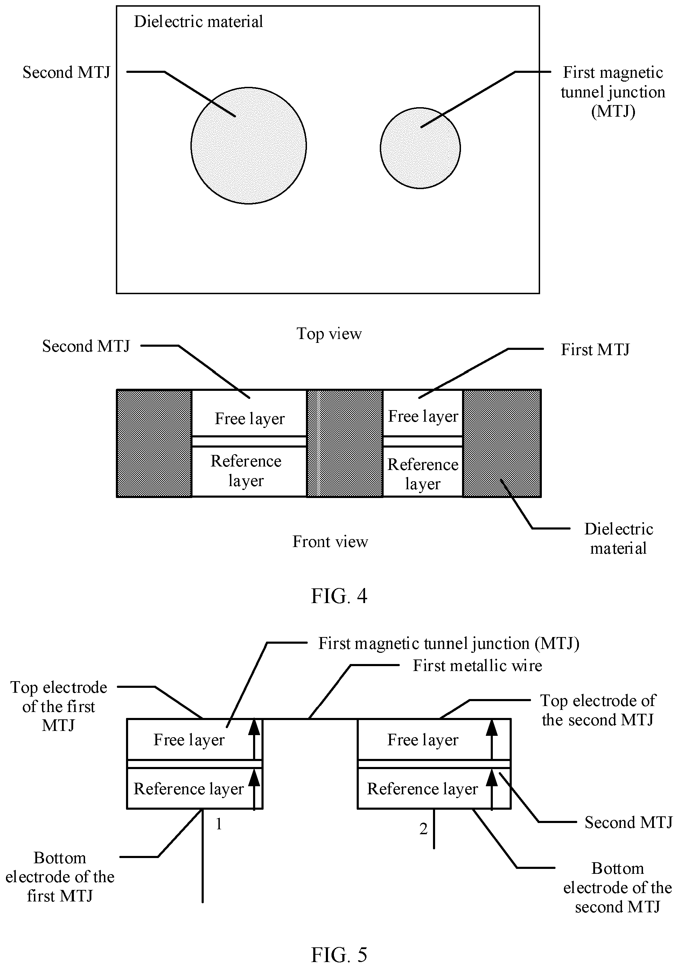

FIG. 4 is a schematic diagram of an example of a storage unit not forming part of the invention.

With reference to FIG. 4, in this embodiment of this application, in an example implementation, in a process of preparing the first MTJ and the second MTJ, after a film layer structure is formed through one time of thin film deposition on a wafer, the first MTJ and the second MTJ are etched at different locations of the film layer structure. A material at other locations other than the first MTJ and the second MTJ is a dielectric material. The first MTJ and the second MTJ have different dimensions. For example, if the first MTJ and the second MTJ are in a shape of a cylinder, a critical dimension (critical dimension, CD) of a circular surface of the first MTJ is different from that of a circular surface of the second MTJ. In an example implementation, because the first MTJ and the second MTJ are located at the same layer of thin film, the first MTJ and the second MTJ have the same resistance area product (resistance area, RA). MTJs formed in the same film layer structure have the same thickness. Therefore, the first MTJ and the second MTJ have the same thickness. Optionally, the first MTJ and the second MTJ may be in a shape of a cylinder. When the first MTJ and the second MTJ are cylinders, a diameter of a circular surface of the first MTJ is different from that of a circular surface of the second MTJ. The first MTJ and the second MTJ may be in a shape of an elliptical cylinder. When the first MTJ and the second MTJ are elliptical cylinders, a superficial area of an elliptical surface of the first MTJ may be different from that of an elliptical surface of the second MTJ. The first MTJ and the second MTJ may be alternatively in another shape. This is not specifically limited herein.

Currents with different directions and different magnitudes flow through the first MTJ and the second MTJ, thereby changing a resistance status of the first MTJ and/or the second MTJ.

In this example, that the first MTJ is less than the second MTJ shown in FIG. 4 is merely used as an example for description. In an actual application process, the first MTJ may be less than the second MTJ, or the second MTJ may be less than the first MTJ. This is not specifically limited herein.

In this example, if the first MTJ and the second MTJ are both in a shape of a cylinder, the CD may be a diameter of the MTJ. If the first MTJ and the second MTJ are in a shape of an elliptical cylinder, the CD may be a minor axis length of an elliptical surface of the MTJ. If the first MTJ and the second MTJ are in another shape, the CD may be alternatively another parameter. This is not specifically limited herein.

The following example is used for description below: The first MTJ and the second MTJ are in a shape of a cylinder, a CD₁ of the first MTJ is different from a CD₂ of the second MTJ, and the first MTJ and the second MTJ are at the same layer of the film layer structure and are formed through one time of thin film deposition.

In this example, a resistance area product (resistance area, RA) may be usually tested by using a current in-plane tunneling method. The RA reflects a thickness and quality of a tunneling layer. The first MTJ and the second MTJ are at the same layer of the film layer structure and are formed through one time of thin film deposition. Therefore, a thickness and quality of a tunneling layer of the first MTJ are the same are the same as a thickness and quality of a tunneling layer of the second MTJ. Therefore, an RA₁ of the first MTJ is the same as an RA₂ of the second MTJ. The following relationship exists between a resistance R of the MTJ and a CD of the MTJ: R=4RA/πCD². In a general design process, the resistance R can be changed through changing the CD of the MTJ because the CD is inversely proportional to the R. As shown in FIG. 2 and FIG. 3, when the RA₁ of the first MTJ is the same as the RA₂ of the second MTJ, the CD₁ is less than the CD₂, and the R₁ is greater than the R₂. Therefore, the first MTJ and the second MTJ have different initial resistance values. In addition, an overturn current of the MTJ is positively correlated with a volume of the MTJ, and a volume of the first MTJ is less than a volume of the second MTJ. Therefore, an overturn current I₁ of the first MTJ is less than an overturn current I₂ of the second MTJ.

In this example, as shown in FIG. 2 and FIG. 3, each MTJ includes a reference layer and a free layer. The reference layer has a fixed magnetization direction. The magnetization direction is not changed due to an external impact. A magnetization direction of the free layer may be changed due to an impact from an external current. If the magnetization direction of the free layer is the same as the magnetization direction of the reference layer of the MTJ, a resistance value of the MTJ is a low resistance value, and the MTJ presents a low resistance status. If the magnetization direction of the free layer is opposite to the magnetization direction of the reference layer of the MTJ, a resistance value of the MTJ is a high resistance value, and the MTJ presents a high resistance status. Four resistance statuses may be distinguished based on different resistance statuses of two MTJs connected in series.

The following describes four types of resistance statuses in detail.

In this example, an initial resistance value of the first MTJ is different from an initial resistance value of the second MTJ. The initial resistance value of the first MTJ is a first resistance value, a resistance value of the first MTJ in a high resistance status is a second resistance value, and a resistance value of the first MTJ in a low resistance status is a third resistance value. In this way, the first MTJ has two resistance statuses. Correspondingly, the first MTJ has two storage statuses. Likewise, it can be learned that the initial resistance value of the second MTJ is a fourth resistance value, a resistance value of the second MTJ in a high resistance status is a fifth resistance value, and a resistance value of the second MTJ in a low resistance status is a sixth resistance value. In this way, the second MTJ has two resistance statuses. Correspondingly, the second MTJ has two storage statuses. After the first MTJ and the second MTJ are connected in series, there may be four resistance statuses, and correspondingly there are four storage statuses.

For example, in this example, that the magnetization directions of the reference layers of the first MTJ and the second MTJ are both upward is used as an example for description. In an actual application process, optionally, the magnetization direction of the reference layer of the first MTJ may be the same as the magnetization direction of the reference layer of the second MTJ. The magnetization direction of the reference layer of the first MTJ may be different from the magnetization direction of the reference layer of the second MTJ. This is not specifically limited herein. Optionally, the magnetization direction of the reference layer of the first MTJ may be upward or downward, and the magnetization direction of the reference layer of the second MTJ may be upward or downward. This is not specifically limited herein.

Resistance status 1: the first MTJ in the low resistance status + the second MTJ in the low resistance status.

FIG. 5 is a schematic diagram of another example of a storage unit not forming part of the invention.

As shown in FIG. 5, for example, that the top electrodes of the first MTJ and the second MTJ are connected by using the first metallic wire is used as an example for description. If a magnetic field direction of the reference layer is the same as that of the free layer of the first MTJ, the first MTJ presents the low resistance status. Likewise, it can be learned that if a magnetic field direction of the reference layer is the same as that of the free layer of the second MTJ, the second MTJ presents the low resistance status.

Resistance status 2: the first MTJ in the high resistance status + the second MTJ in the low resistance status.

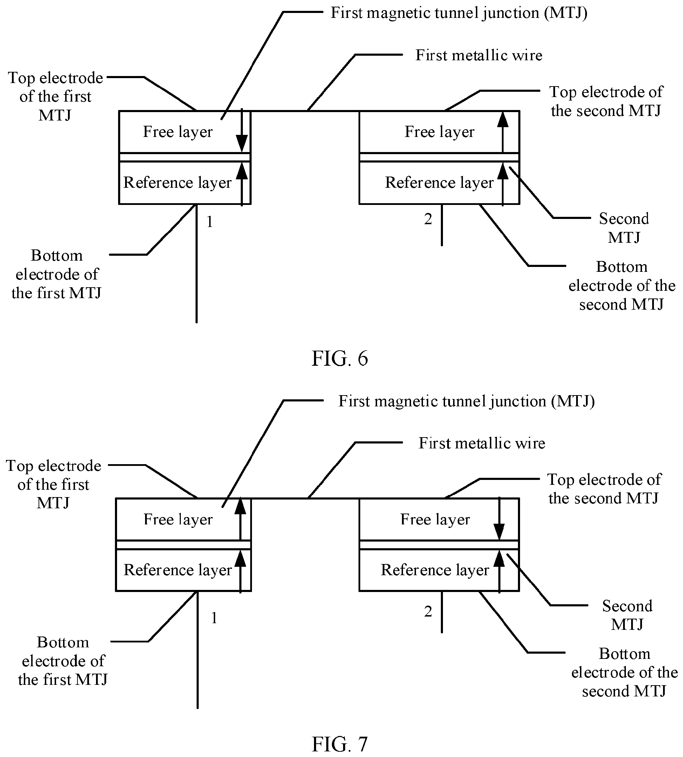

FIG. 6 is a schematic diagram of another example of a storage unit not forming part of the invention.

As shown in FIG. 6, for example, that the top electrodes of the first MTJ and the second MTJ are connected by using the first metallic wire is used as an example for description. If a magnetic field direction of the reference layer is opposite to that of the free layer of the first MTJ, the first MTJ presents the high resistance status. If a magnetic field direction of the reference layer is the same as that of the free layer of the second MTJ, the second MTJ presents the low resistance status.

Resistance status 3: the first MTJ in the low resistance status + the second MTJ in the high resistance status.

FIG. 7 is a schematic diagram of another example of a storage unit not forming part of the invention.

As shown in FIG. 7, for example, that the top electrodes of the first MTJ and the second MTJ are connected by using the first metallic wire is used as an example for description. If a magnetic field direction of the reference layer is the same as that of the free layer of the first MTJ, the first MTJ presents the low resistance status. If a magnetic field direction of the reference layer is opposite to that of the free layer of the second MTJ, the second MTJ presents the high resistance status.

Resistance status 4: the first MTJ in the high resistance status + the second MTJ in the high resistance status.

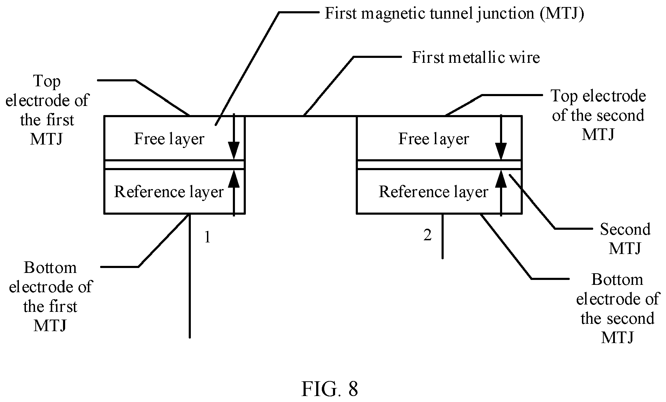

FIG. 8 is a schematic diagram of another example of a storage unit not forming part of the invention.

As shown in FIG. 8, for example, that the top electrodes of the first MTJ and the second MTJ are connected by using the first metallic wire is used as an example for description. If a magnetic field direction of the reference layer is opposite to that of the free layer of the first MTJ, the first MTJ presents the high resistance status. If a magnetic field direction of the reference layer is opposite to that of the free layer of the second MTJ, the second MTJ presents the high resistance status.

In this example, the overturn current has current intensity that can change the magnetic field direction of the free layer of the MTJ when a current direction is different from the magnetic field direction of the free layer. The overturn current may be different when a parallel state is switched to an anti-parallel state and when an anti-parallel state is switched to a parallel state. The parallel state indicates that the magnetic field direction of the free layer is the same as that of the reference layer. The anti-parallel state indicates that the magnetic field direction of the free layer is opposite to that of the reference layer. When a current value provided by the external is greater than the overturn current, the magnetization direction of the free layer changes, and therefore, the resistance status of the MTJ changes. The foregoing embodiment describes four types of resistance statuses. The following describes in detail mutual switching between the types of resistance statuses.

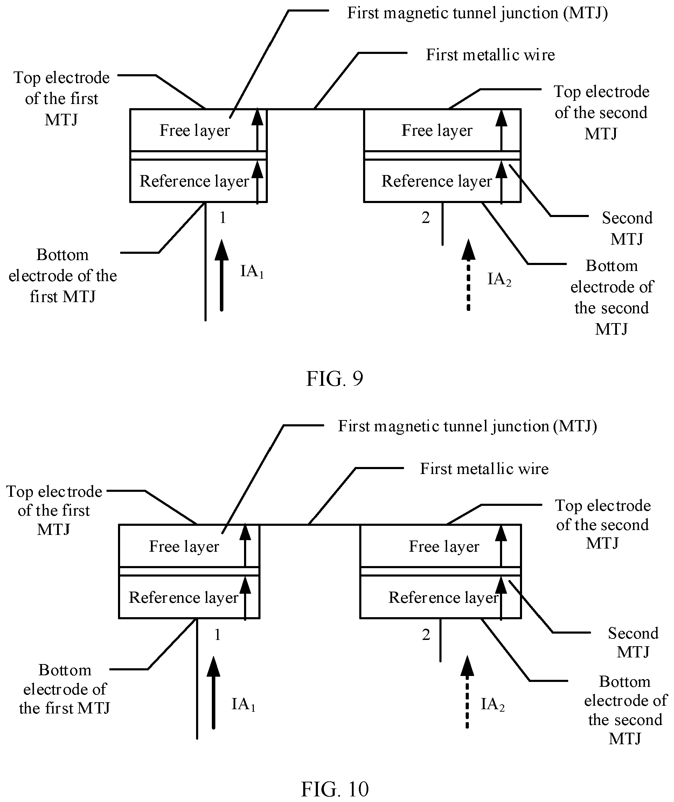

In this example, the resistance status 1 is used as an example for description. A current IA₁ or a current IA₂ flows into the first MTJ and the second MTJ that are connected in series. The IA₁ is a current that flows into the storage unit from the bottom electrode of the first MTJ, flows through the first metallic wire, and is exported from the bottom electrode of the second MTJ. A direction of the current is a direction from 1 to 2 in FIG. 9. The IA₂ is a current that flows into the storage unit from the bottom electrode of the second MTJ, flows through the first metallic wire, and is exported from the bottom electrode of the first MTJ. A direction of the current is a direction from 2 to 1 in FIG. 9. The IA₁ and the IA₂ are currents with the same magnitude and opposite directions. The overturn current of the first MTJ is named I₁, and the overturn current of the second MTJ is named I₂.

FIG. 9 is a schematic diagram of another example of a storage unit not forming part of the invention.

For example, a resistance status of the storage unit shown in FIG. 9 is the resistance status 2. After a current in a direction shown in FIG. 9 flows into the first MTJ from the bottom electrode of the first MTJ, the current flows through the second MTJ by using the first metallic wire, and then is output to another module from the bottom electrode of the second MTJ.

If IA₁<I₁<I₂, after the IA₁ flows into the first MTJ and the second MTJ, a magnetic field of the free layer of the first MTJ is not overturned, and a magnetic field of the free layer of the second MTJ is not overturned. The resistance status of the storage unit is not changed.

If I₁<IA₁<I₂, after the IA₁ flows into the first MTJ and the second MTJ, because the magnetic field direction of the first MTJ is the same as the current direction, a magnetic field of the free layer of the first MTJ is not overturned. Because the IA₁ is less than the overturn current I₂ of the second MTJ, a magnetic field of the free layer of the second MTJ is also not overturned. The resistance status of the storage unit is not changed.

If I₁<I₂<IA₁, after the IA₁ flows into the first MTJ and the second MTJ, the IA₁ is greater than the overturn current I₁ of the first MTJ. Because the magnetic field direction of the first MTJ is the same as the current direction, a magnetic field of the free layer of the first MTJ is not overturned. The IA₁ is greater than the overturn current I₂ of the second MTJ, and the magnetic field direction of the second MTJ is opposite to the current direction. Therefore, the magnetic field of the free layer of the second MTJ is overturned. The resistance status of the storage unit is switched from the first MTJ in the low resistance status + the second MTJ in the low resistance status to the first MTJ in the low resistance status + the second MTJ in the high resistance status. In other words, the resistance status of the storage unit is switched from the resistance status 1 to the resistance status 3.

In this example, when the storage unit is in the resistance status 1, after the current IA₂ flows into the second MTJ from the bottom electrode of the second MTJ, the current flows through the first MTJ by using the first metallic wire, and then is output to another module from the bottom electrode of the first MTJ. Under this condition, switching of the resistance status of the storage unit after the IA₂ with different magnitudes is input to the storage unit is similar to the principle described in the foregoing embodiment. Details are not described herein again.

In this example, the resistance status 2 is used as an example for description. The current IA₁ flows into the first MTJ and the second MTJ that are connected in series. The overturn current of the first MTJ is named I₁, and the overturn current of the second MTJ is named I₂.

FIG. 10 is a schematic diagram of another example of a storage unit not forming part of the invention.

For example, the resistance status of the storage unit shown in FIG. 10 is the resistance status 2. After a current IA₁ in a direction shown in FIG. 10 flows into the first MTJ from the bottom electrode of the first MTJ, the current flows through the second MTJ by using the first metallic wire, and then is output to another module from the bottom electrode of the second MTJ.

If IA₁<I₁<I₂, after the IA₁ flows into the first MTJ and the second MTJ, a magnetic field of the free layer of the first MTJ is not overturned, and a magnetic field of the free layer of the second MTJ is not overturned. The resistance status of the storage unit is not changed.

If I₁<IA₁<I₂, after the IA₁ flows into the first MTJ and the second MTJ, the IA₁ is greater than the overturn current I₁ of the first MTJ. Because the magnetic field direction of the first MTJ is opposite to the current IA₁ direction, a magnetic field of the free layer of the first MTJ is overturned. The IA₁ is less than the overturn current I₂ of the second MTJ, and the magnetic field direction of the second MTJ is opposite to the current IA₁ direction. Therefore, the magnetic field of the free layer of the second MTJ is not overturned. The resistance status of the storage unit is switched from the first MTJ in the high resistance status + the second MTJ in the low resistance status to the first MTJ in the low resistance status + the second MTJ in the low resistance status. In other words, the resistance status of the storage unit is switched from the resistance status 2 to the resistance status 1.

If I₁<I₂<IA₁, after the IA₁ flows into the first MTJ and the second MTJ, the IA₁ is greater than the overturn current I₁ of the first MTJ. Because the direction of the IA₁ is opposite to the direction of the free layer of the first MTJ, a magnetic field of the free layer of the first MTJ is overturned. Likewise, it may be learned that the IA₁ is greater than the overturn current I₂ of the second MTJ, and the direction of the IA₁ is opposite to the direction of the free layer of the second MTJ. Therefore, the magnetic field of the free layer of the second MTJ is overturned. The resistance status of the storage unit is switched from the first MTJ in the high resistance status + the second MTJ in the low resistance status to the first MTJ in the low resistance status + the second MTJ in the high resistance status. In other words, the resistance status of the storage unit is switched from the resistance status 2 to the resistance status 3.

In this example, when the storage unit is in the resistance status 2, after the current IA₂ flows into the second MTJ from the bottom electrode of the second MTJ, the current flows through the first MTJ by using the first metallic wire, and then is output to another module from the bottom electrode of the first MTJ. Under this condition, because the magnetic field directions of the free layers of the first MTJ and the second MTJ are the same as the direction of the IA₂, the resistance status of the storage unit is not switched after the IA₂ with different magnitudes are input to the storage unit.

In this example, if the storage unit is in the resistance status 3, a process of switching the resistance status after the IA₁ and the IA₂ with different directions and different magnitudes is similar to a process of switching the resistance status when the storage unit is in the resistance status 2 in the foregoing example. Details are not described herein again.

In this example, if the storage unit is in the resistance status 4, a process of switching the resistance status after the IA₁ and the IA₂ with different directions and different magnitudes is similar to a process of switching the resistance status when the storage unit is in the resistance status 1 in the foregoing example. Details are not described herein again.

In this example, switching of the resistance status may further be understood from a data write perspective.

### (1) Obtain the resistance status 1

In this example, first, the IA₂ in the direction from 2 to 1 shown in FIG. 5 is applied to the storage unit at the bottom electrode of the second MTJ. Herein, I₁<I₂<IA₂ is met. In this case, the magnetic field direction of the free layer is opposite to that of the reference layer of the first MTJ in the storage unit, and the first MTJ is in the high resistance status. The magnetic field direction of the free layer is the same as that of the reference layer of the second MTJ, and the second MTJ is in the low resistance status. Then, the IA₁ in the direction from 1 to 2 shown in FIG. 5 is applied to the storage unit at the bottom electrode of the first MTJ. Herein, I₁<IA₁<I₂ is met. In this case, the magnetic field direction of the free layer is the same as that of the reference layer of the first MTJ in the storage unit, and the first MTJ is in the low resistance status. The magnetic field direction of the free layer is the same as that of the reference layer of the second MTJ, and the second MTJ is in the low resistance status. The storage unit is in the resistance status 1.

### (2) Obtain the resistance status 2

In this example, the IA₂ in the direction from 2 to 1 shown in FIG. 6 is applied to the storage unit at the bottom electrode of the second MTJ. Herein, I₁<I₂<IA₂ is met. In this case, the magnetic field direction of the free layer is opposite to that of the reference layer of the first MTJ in the storage unit, and the first MTJ is in the high resistance status. The magnetic field direction of the free layer is the same as that of the reference layer of the second MTJ, and the second MTJ is in the low resistance status. The storage unit is in the resistance status 2.

### (3) Obtain the resistance status 3

In this example, the IA₁ in the direction from 1 to 2 shown in FIG. 7 is applied to the storage unit at the bottom electrode of the first MTJ. Herein, I₁<I₂<IA₁ is met. In this case, the magnetic field direction of the free layer is the same as that of the reference layer of the first MTJ in the storage unit, and the first MTJ is in the low resistance status. The magnetic field direction of the free layer is opposite to that of the reference layer of the second MTJ, and the second MTJ is in the high resistance status. The storage unit is in the resistance status 3.

### (4) Obtain the resistance status 4

In this example, first, the IA₁ in the direction from 1 to 2 shown in FIG. 8 is applied to the storage unit at the bottom electrode of the first MTJ. Herein, I₁<I₂<IA₁ is met. In this case, the magnetic field direction of the free layer is the same as that of the reference layer of the first MTJ in the storage unit, and the first MTJ is in the low resistance status. The magnetic field direction of the free layer is opposite to that of the reference layer of the second MTJ, and the second MTJ is in the high resistance status. Then, the IA₂ in the direction from 2 to 1 shown in FIG. 8 is applied to the storage unit at the bottom electrode of the second MTJ. Herein, I₁<IA₂<I₂ is met. In this case, the magnetic field direction of the free layer is opposite to that of the reference layer of the first MTJ in the storage unit, and the first MTJ is in the high resistance status. The magnetic field direction of the free layer is opposite to that of the reference layer of the second MTJ, and the second MTJ is in the high resistance status. The storage unit is in the resistance status 4.

In this example, that the first MTJ is less than the second MTJ shown in FIG. 5, FIG. 6, FIG. 7, FIG. 8, FIG. 9, and FIG. 10 is merely used as an example for description. In an actual application process, the first MTJ may be less than the second MTJ, or the second MTJ may be less than the first MTJ. This is not specifically limited herein.

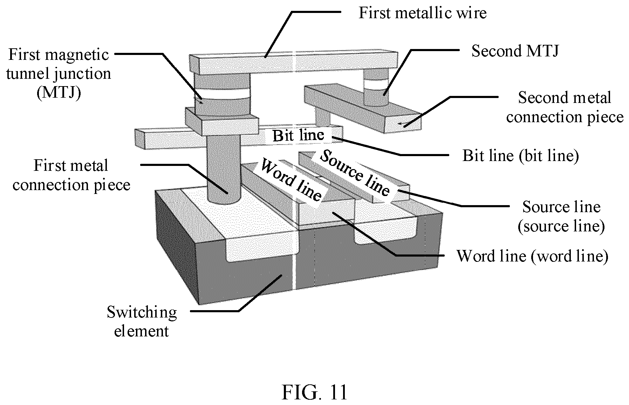

FIG. 11 is a schematic diagram of another example of a storage unit not forming part of the invention.

As shown in FIG. 11, in this embodiment of this application, the storage unit includes a first metal connection piece, a second metal connection piece, and a switching element.

A second electrode of a first MTJ is electrically connected to a first end of the switching element by using the first metal connection piece.

A second electrode of a second MTJ is electrically connected to a bit line (bit line) by using the second metal connection piece.

A second end of the switching element is electrically connected to a source line (source line).

A control end of the switching element is electrically connected to a word line (word line).

In an implementation, if the switching element is a transistor, the word line is electrically connected to a gate of the transistor, the source line is electrically connected to a source of the transistor, and the second metal connection piece is electrically connected to a drain of the transistor. If the switching element is another element, another connection manner may exist. This is not specifically limited herein.

The switching element inputs currents with different magnitudes to the first MTJ and the second MTJ by using the first metal connection piece, or the bit line inputs currents with different magnitudes to the first MTJ and the second MTJ by using the second metal connection piece. Then, a resistance status of the first MTJ and/or the second MTJ is changed.

In this example, the second electrode of the first MTJ is electrically connected to the switching element by using the first metal connection piece. Optionally, the switching element may be a transistor, the switching element may be a gate tube, or the switching element may be another electronic element having a control function. This is not specifically limited herein. Optionally, the second electrode of the first MTJ is electrically connected to the switching element by using the first metal connection piece. Alternatively, many other metal connection pieces configured to implement an electrical connection may be included between the second electrode of the first MTJ and the first metal connection piece. This is not specifically limited herein. Likewise, optionally, it may be learned that the second electrode of the second MTJ is electrically connected to the bit line by using the second metal connection piece. Alternatively, many other metal connection pieces configured to implement an electrical connection may be included between the second electrode of the second MTJ and the second metal connection piece. This is not specifically limited herein. Optionally, the second electrodes of the first MTJ and the second MTJ may be top electrodes, and the second electrodes of the first MTJ and the second MTJ may be bottom electrodes. This is not specifically limited herein.

In this example, a signal module is configured to input an electrical signal to a storage unit. In a possible implementation, a memory receives a data recording indication from an electronic device. The word line and the bit line may select a location that requires data input in the storage unit. The electronic device controls, by using the source line, the switching element to open and input the currents to the first MTJ and the second MTJ, or the electronic device inputs the currents to the second MTJ and the first MTJ by using the bit line, to change the resistance statuses of the first MTJ and the second MTJ. Different resistance statuses of the first MTJ and the second MTJ are obtained through combination, to implement data storage.

In this example, the switching element may input currents with different directions and different magnitudes to the first MTJ and the second MTJ by using the first metal connection piece, thereby changing the resistance status of the first MTJ and/or the second MTJ. A manner in which the switching element changes the resistance status by using the current is similar to the manners described in FIG. 5 to FIG. 10 in the foregoing examples. Details are not described herein again.

In an embodiment of this application, the storage unit further includes a third MTJ, a first metallic wire, a second metallic wire, a first metal connection piece, a second metal connection piece, and a switching element.

A second electrode of the first MTJ is electrically connected to a first end of the switching element by using the first metal connection piece.

The second MTJ is connected in series to the third MTJ by using the second metallic wire.

A first end of the second metallic wire is electrically connected to a second electrode of the second MTJ. A second end of the second metallic wire is electrically connected to a first electrode of the third MTJ. The second electrode of the second MTJ and the first electrode of the third MTJ are both top electrodes or bottom electrodes.

A second electrode of the third MTJ is electrically connected to a bit line by using the second metal connection piece.

A second end of the switching element is electrically connected to a source line.

A control end of the switching element is electrically connected to a word line.

The switching element inputs currents with different directions and different magnitudes to the first MTJ, the second MTJ, and the third MTJ by using the first metal connection piece, thereby changing the resistance status of the first MTJ, the second MTJ, and/or the third MTJ.

In this embodiment of this application, functions of components in a connection module and a signal module are similar to the functions in the example described in FIG. 11. Details are not described herein again.

In this embodiment of this application, that the first MTJ is bigger than the second MTJ shown in FIG. 11 is merely used as an example for description. In an actual application process, the first MTJ may be less than the second MTJ, or the second MTJ may be less than the first MTJ. This is not specifically limited herein.

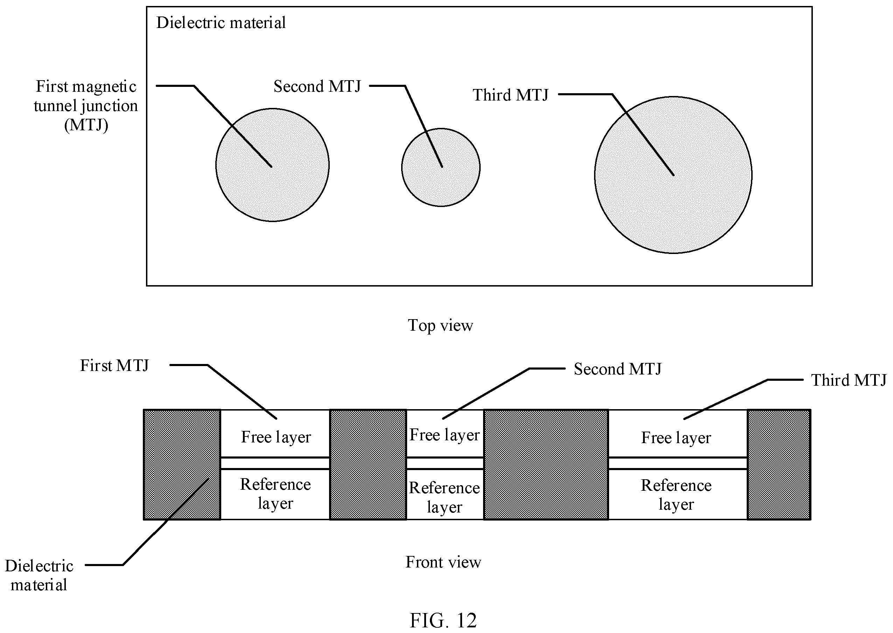

FIG. 12 is a schematic diagram of another embodiment of a storage unit according to an embodiment of this application.

In this embodiment of this application, as shown in FIG. 12, the first MTJ, the second MTJ, and the third MTJ have electrodes on the same layer. After a film layer structure is formed through one time of thin film deposition on a wafer, the first MTJ, the second MTJ, and the third MTJ are etched at different locations of the film layer structure, and the first MTJ, the second MTJ, and the third MTJ have different dimensions. The first MTJ, the second MTJ, and the third MTJ are connected in series in a head-to-tail connection manner. For example, if a top electrode of the first MTJ and a top electrode of the second MTJ are connected in series by using the first metallic wire, a bottom electrode of the second MTJ and a bottom electrode of the third MTJ are connected in series by using the second metallic wire. If a bottom electrode of the first MTJ and a bottom electrode of the second MTJ are connected in series by using the first metallic wire, a top electrode of the second MTJ and a top electrode of the third MTJ are connected in series by using the second metallic wire.

In this embodiment of this application, the switching element inputs currents with different directions and different magnitudes to the first MTJ, the second MTJ, and the third MTJ by using the first metal connection piece, thereby changing the resistance status of the first MTJ, the second MTJ, and/or the third MTJ. After the storage unit has three MTJs, there are 2³ resistance statuses. After the storage unit has N MTJs, there are 2^{N} resistance statuses. A manner in which the switching element changes the resistance status by using the current is similar to the manners described in FIG. 5 to FIG. 10 in the foregoing examples. Details are not described herein again.

In this embodiment of this application, the first MTJ, the second MTJ, and the third MTJ have a plurality of reasonable arrangement manners. A specific arrangement manner is described in the following embodiment.

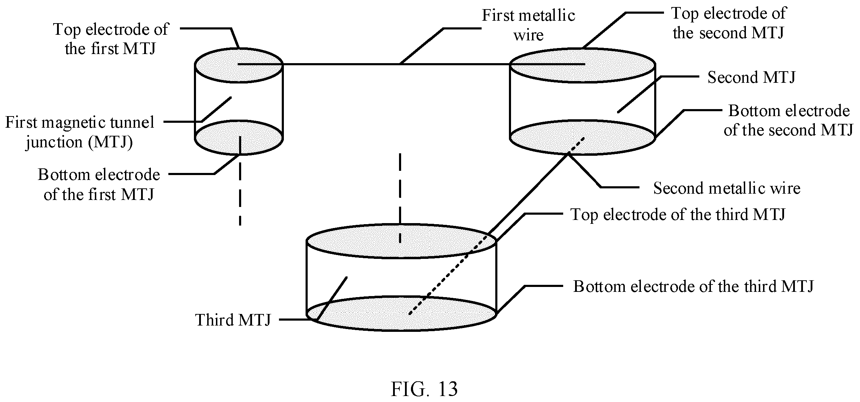

FIG. 13 is a schematic diagram of another embodiment of a storage unit according to an embodiment of this application.
1. An included angle between the first metallic wire and the second metallic wire is an acute angle. Connection lines between a center of the first MTJ, a center of the second MTJ, and a center of the third MTJ form an acute triangle.

With reference to FIG. 13, in this embodiment of this application, the first MTJ, the second MTJ, and the third MTJ are arranged in a triangle manner. Further, space occupied when the three MTJs are arranged can be reduced, and a volume of the memory can be further reduced.

2. In an example not forming part of the invention, the first metallic wire is parallel with the second metallic wire. Connection lines between a center of the first MTJ, a center of the second MTJ, and a center of the third MTJ form a straight line.

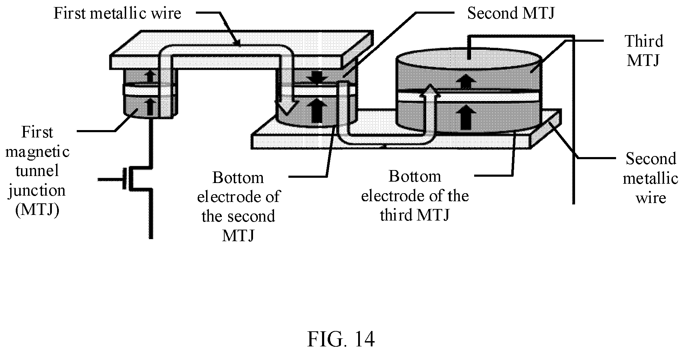

FIG. 14 is a schematic diagram of another example of a storage unit not forming part of the invention.

With reference to FIG. 14, in this embodiment of this application, the first MTJ, the second MTJ, and the third MTJ may be arranged in a straight line manner. Further, space occupied when the three MTJs are arranged can be reduced, and a volume of the memory can be further reduced. Because the first MTJ, the second MTJ, and the third MTJ are connected in series, a current flowing through the first MTJ, the first metallic wire, and the second MTJ is the same as a current flowing through the second MTJ, the second metallic wire, and the third MTJ.

In this example, the storage unit further includes a third MTJ, a first metallic wire, a second metallic wire, a first metal connection piece, a second metal connection piece, and a switching element.

A second electrode of the first MTJ is electrically connected to a first end of the switching element by using the first metal connection piece.

The second MTJ is connected in series to the third MTJ by using the second metallic wire.

A first end of the second metallic wire is electrically connected to a second electrode of the second MTJ. A second end of the second metallic wire is electrically connected to a first electrode of the third MTJ. The second electrode of the second MTJ and the first electrode of the third MTJ are both top electrodes or bottom electrodes.

A second electrode of the third MTJ is electrically connected to a bit line by using the second metal connection piece.

A second end of the switching element is electrically connected to a source line.

A control end of the switching element is electrically connected to a word line.

The switching element inputs currents with different directions and different magnitudes to the first MTJ, the second MTJ, the third MTJ, and the fourth MTJ by using the first metal connection piece, or the bit line inputs currents with different directions and different magnitudes to the fourth MTJ, the third MTJ, the second MTJ, and the first MTJ by using the second metal connection piece. Then, a resistance status of the first MTJ, the second MTJ, the third MTJ, and/or the fourth MTJ is changed.

In this example, functions of components in a connection module and a signal module are similar to the functions in the example described in FIG. 11. Details are not described herein again.

In this example of this application, the switching element inputs currents with different directions and different magnitudes to the first MTJ, the second MTJ, and the third MTJ by using the first metal connection piece, thereby changing the resistance status of the first MTJ, the second MTJ, and/or the third MTJ. After the storage unit has three MTJs, there are 2³ resistance statuses. After the storage unit has N MTJs, there are 2^{N} resistance statuses. A manner in which the switching element changes the resistance status by using the current is similar to the manners described in FIG. 5 to FIG. 10 in the foregoing examples. Details are not described herein again.

Dimension relationships between the first MTJ, the second MTJ, and the third MTJ shown in FIG. 12, FIG. 13, and FIG. 14 are merely used as examples for description. A specific dimension relationship is not limited herein.

The first MTJ, the second MTJ, the third MTJ, and the fourth MTJ have a plurality of reasonable arrangement manners. A specific arrangement manner is described in the following embodiment.

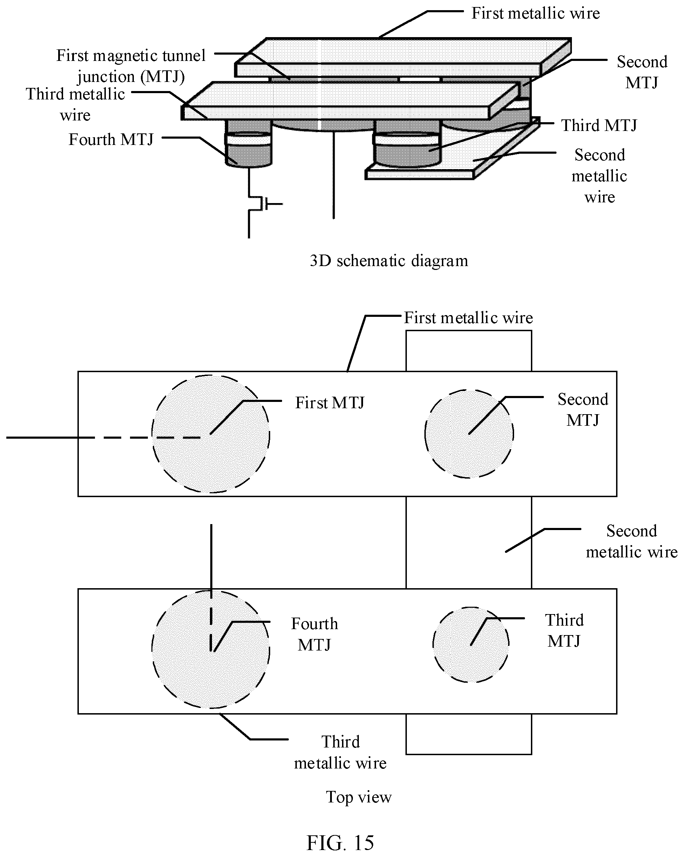

FIG. 15 is a schematic diagram of another embodiment of a storage unit according to an embodiment of this application.
1. Connection lines between a center of the first MTJ, a center of the second MTJ, a center of the third MTJ, and a center of the fourth MTJ form a quadrangle.

With reference to FIG. 15, in this embodiment of this application, the first MTJ, the second MTJ, the third MTJ, and the fourth MTJ are arranged in a quadrangle manner. Further, space occupied when the four MTJs are arranged can be reduced, and a volume of the memory can be further reduced.

2. In an example not forming part of the invention, the first metallic wire is parallel with the second metallic wire. Connection lines between a center of the first MTJ, a center of the second MTJ, a center of the third MTJ, and a center of the fourth MTJ form a straight line.

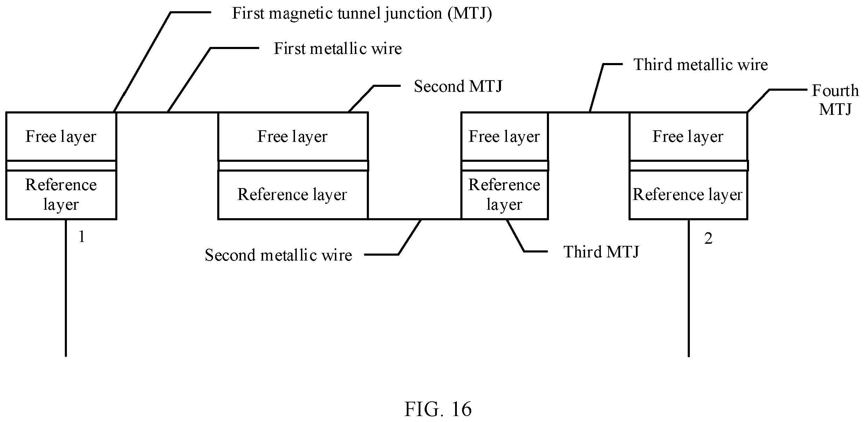

FIG. 16 is a schematic diagram of another example of a storage unit not forming part of the invention.

With reference to FIG. 16, in this example, the first MTJ, the second MTJ, the third MTJ, and the fourth MTJ may be arranged in a straight line manner. Further, space occupied when the four MTJs are arranged can be reduced, and a volume of the memory can be further reduced.

In this example, the bit line, the word line, and the source line have a plurality of reasonable arrangement manners. A specific arrangement manner is described in the following.
1. The bit line is parallel with the first metallic wire, the bit line is perpendicular to the word line, and the bit line is perpendicular to the source line.

A solution in which the storage unit includes two MTJs is used as an example for description. As shown in FIG. 11, the bit line is parallel with the first metallic wire, the bit line is perpendicular to the word line, and the bit line is perpendicular to the source line. Space occupied when the bit line, the word line, and the source line are arranged can be reduced, and a volume of the memory can be further reduced.

Dimension relationships between the first MTJ, the second MTJ, the third MTJ, and the fourth MTJ shown in FIG. 15 and FIG. 16 are merely used as examples for description. A specific dimension relationship is not limited herein.

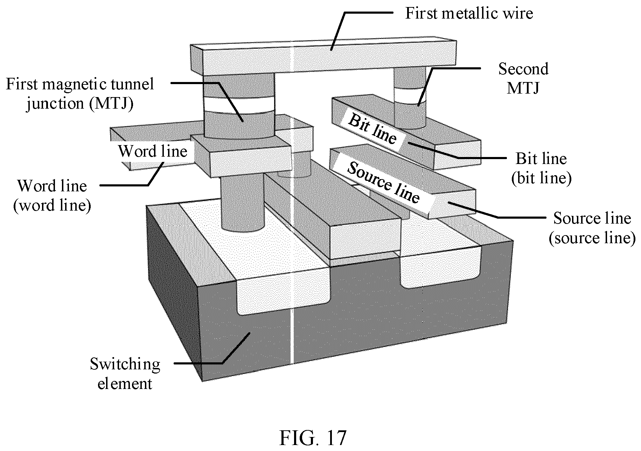

FIG. 17 is a schematic diagram of another example of a storage unit example not forming part of the invention.

2. The bit line is perpendicular to the first metallic wire, the bit line is perpendicular to the word line, and the bit line is parallel with the source line.

In this example, a solution in which the storage unit includes two MTJs is used as an example for description. As shown in FIG. 17, the bit line is perpendicular to the first metallic wire, the bit line is perpendicular to the word line, and the bit line is parallel with the source line. Space occupied when the bit line, the word line, and the source line are arranged can be reduced, and a volume of the memory can be further reduced.

That the first MTJ is bigger than the second MTJ shown in FIG. 17 is merely used as an example for description. In an actual application process, the first MTJ may be less than the second MTJ, or the second MTJ may be less than the first MTJ. This is not specifically limited herein.

In this embodiment of this application, a storage array includes a word line, a bit line, a source line, and at least one storage unit. One storage unit may include three MTJs, or may include four MTJs. A series connection manner of the N MTJs is similar to a series connection manner described in the foregoing embodiment. This is not specifically limited herein.

Described above is a storage unit. The first electrode of the first MTJ included in the storage unit is connected in series to the first electrode of the second MTJ by using the first metallic wire. The first electrode of the first MTJ and the first electrode of the second MTJ are electrodes of the same layer. In other words, the first electrode of the first MTJ and the second electrode of the second MTJ are both top electrodes or bottom electrodes. Currents with different directions and different magnitudes flow through the first MTJ and the second MTJ, thereby changing a resistance status of the first MTJ and/or the second MTJ. The electrodes of the same layer of the first MTJ and the second MTJ are connected. A direction from the bottom electrode to the top electrode of the first MTJ and the second MTJ is used as a reference direction. A current in the first MTJ and a current in the second MTJ have the same magnitude and opposite directions. An effect of the current on a magnetic field direction of a free layer of the first MTJ and an effect of the current on a magnetic field direction of a free layer of the second MTJ are opposite. Further, polymorphic storage may be implemented by using a combination of different resistance values of the first MTJ and the second MTJ, thereby improving storage efficiency of a memory.

The storage unit and the memory provided in the embodiments of this application are described in detail above. Specific examples are used in this specification to describe the principles and the implementations of this application. The foregoing embodiments are described only to help understand this application. In addition, a person of ordinary skill in the art may make modifications to the specific implementations and the application scope according to the appended independent claims.

## Claims

1. A storage unit, wherein the storage unit comprises a first magnetic tunnel junction, MTJ, having two resistance statuses, a second MTJ having two resistance statuses, and a first metallic wire;
the first MTJ is connected in series to the second MTJ by using the first metallic wire; and
a first end of the first metallic wire is electrically connected to a first electrode of the first MTJ, a second end of the first metallic wire is electrically connected to a first electrode of the second MTJ, and the first electrode of the first MTJ and the first electrode of the second MTJ are both top electrodes or bottom electrodes;
wherein the storage unit further comprises a third MTJ, the first metallic wire, a second metallic wire, a first metal connection piece, a second metal connection piece, and a switching element;
a second electrode of the first MTJ is electrically connected to a first end of the switching element by using the first metal connection piece;
the second MTJ is connected in series to the third MTJ by using the second metallic wire;
a first end of the second metallic wire is electrically connected to a second electrode of the second MTJ, a second end of the second metallic wire is electrically connected to a first electrode of the third MTJ, and the second electrode of the second MTJ and the first electrode of the third MTJ are both top electrodes or bottom electrodes;
a second electrode of the third MTJ is electrically connected to a bit line by using the second metal connection piece;
a second end of the switching element is electrically connected to a source line; and
a control end of the switching element is electrically connected to a word line;
wherein the storage unit has eight resistance statuses; and
wherein an included angle between the first metallic wire and the second metallic wire is an acute angle, and connection lines between a center of the first MTJ, a center of the second MTJ, and a center of the third MTJ form an acute triangle.

2. A storage unit, wherein the storage unit comprises a first magnetic tunnel junction, MTJ, having two resistance statuses, a second MTJ having two resistance statuses, and a first metallic wire;
the first MTJ is connected in series to the second MTJ by using the first metallic wire; and
a first end of the first metallic wire is electrically connected to a first electrode of the first MTJ, a second end of the first metallic wire is electrically connected to a first electrode of the second MTJ, and the first electrode of the first MTJ and the first electrode of the second MTJ are both top electrodes or bottom electrodes; wherein the storage unit further comprises a second metallic wire, a third metallic wire, a third MTJ, a fourth MTJ, a first metal connection piece, a second metal connection piece, and a switching element;
a second electrode of the first MTJ is electrically connected to a first end of the switching element by using the first metal connection piece;
the second MTJ is connected in series to the third MTJ by using the second metallic wire;
a first end of the second metallic wire is electrically connected to a second electrode of the second MTJ, a second end of the second metallic wire is electrically connected to a first electrode of the third MTJ, and the second electrode of the second MTJ and the first electrode of the third MTJ are both top electrodes or bottom electrodes;
the third MTJ is connected in series to the fourth MTJ by using the third metallic wire;
a first end of the third metallic wire is electrically connected to a second electrode of the third MTJ, a second end of the third metallic wire is electrically connected to a first electrode of the fourth MTJ, and the second electrode of the third MTJ and the first electrode of the fourth MTJ are both top electrodes or bottom electrodes;
a second end of the switching element is electrically connected to a source line; and
a control end of the switching element is electrically connected to a word line;
wherein the storage unit has sixteen resistance statuses; and
wherein connection lines between a center of the first MTJ, a center of the second MTJ, a center of the third MTJ, and a center of the fourth MTJ form a quadrangle.

3. The storage unit according to any preceding claim, wherein the first MTJ and the second MTJ are located at the same layer of a laminated structure and are formed through one time of thin film deposition.

4. The storage unit according to any one of claims 1 to 3, wherein the bit line is parallel with the first metallic wire, the bit line is perpendicular to the word line, and the bit line is perpendicular to the source line.

5. The storage unit according to any one of claims 1 to 3, wherein the bit line is perpendicular to the first metallic wire, the bit line is perpendicular to the word line, and the bit line is parallel with the source line.

6. A storage array, comprising a word line, a bit line, a source line, and at least one storage unit, wherein
the storage unit is the storage unit according to any one of claims 1 to 5.

7. A memory (100), comprising a storage unit (101) and a controller (102), wherein
the storage unit stores data under control of the controller, and the storage unit is the storage unit according to any one of claims 1 to 5.

8. A computing memory, comprising a storage unit and a controller, wherein
the storage unit stores data and/or calculates data under control of the controller, and the storage unit is the storage unit according to any one of claims 1 to 5.

## Patentansprüche

1. Speicherungseinheit, wobei die Speicherungseinheit einen ersten magnetischen Tunnelübergang, MTJ, der zwei Widerstandszustände aufweist, einen zweiten MTJ, der zwei Widerstandszustände aufweist, und einen ersten metallischen Draht umfasst; der erste MTJ durch Verwenden des ersten metallischen Drahts in Reihe mit dem zweiten MTJ verbunden ist; und
ein erstes Ende des ersten metallischen Drahts mit einer ersten Elektrode des ersten MTJ elektrisch verbunden ist, ein zweites Ende des ersten metallischen Drahts mit einer ersten Elektrode des zweiten MTJ elektrisch verbunden ist und die erste Elektrode des ersten MTJ und die erste Elektrode des zweiten MTJ beide obere Elektroden oder untere Elektroden sind;
wobei die Speicherungseinheit ferner einen dritten MTJ, den ersten metallischen Draht, einen zweiten metallischen Draht, ein erstes Metallverbindungsstück, ein zweites Metallverbindungsstück und ein Schaltelement umfasst;
eine zweite Elektrode des ersten MTJ durch Verwenden des ersten Metallverbindungsstücks mit einem ersten Ende des Schaltelements elektrisch verbunden ist;
der zweite MTJ durch Verwenden des zweiten metallischen Drahts in Reihe mit dem dritten MTJ verbunden ist;
ein erstes Ende des zweiten metallischen Drahts mit einer zweiten Elektrode des zweiten MTJ elektrisch verbunden ist, ein zweites Ende des zweiten metallischen Drahts mit einer ersten Elektrode des dritten MTJ elektrisch verbunden ist und die zweite Elektrode des zweiten MTJ und die erste Elektrode des dritten MTJ beide obere Elektroden oder untere Elektroden sind;
eine zweite Elektrode des dritten MTJ durch Verwenden des zweiten Metallverbindungsstücks mit einer Bitleitung elektrisch verbunden ist;
ein zweites Ende des Schaltelements mit einer Sourceleitung elektrisch verbunden ist; und ein Steuerende des Schaltelements mit einer Wortleitung elektrisch verbunden ist; wobei die Speicherungseinheit acht Widerstandszustände aufweist; und
wobei ein eingeschlossener Winkel zwischen dem ersten metallischen Draht und dem zweiten metallischen Draht ein spitzer Winkel ist und Verbindungsleitungen zwischen einem Mittelpunkt des ersten MTJ, einem Mittelpunkt des zweiten MTJ und einem Mittelpunkt des dritten MTJ ein spitzes Dreieck ausbilden.

2. Speicherungseinheit, wobei die Speicherungseinheit einen ersten magnetischen Tunnelübergang, MTJ, der zwei Widerstandszustände aufweist, einen zweiten MTJ, der zwei Widerstandszustände aufweist, und einen ersten metallischen Draht umfasst; der erste MTJ durch Verwenden des ersten metallischen Drahts in Reihe mit dem zweiten MTJ verbunden ist; und
ein erstes Ende des ersten metallischen Drahts mit einer ersten Elektrode des ersten MTJ elektrisch verbunden ist, ein zweites Ende des ersten metallischen Drahts mit einer ersten Elektrode des zweiten MTJ elektrisch verbunden ist und die erste Elektrode des ersten MTJ und die erste Elektrode des zweiten MTJ beide obere Elektroden oder untere Elektroden sind; wobei die Speicherungseinheit ferner einen zweiten metallischen Draht, einen dritten metallischen Draht, einen dritten MTJ, einen vierten MTJ, ein erstes Metallverbindungsstück, ein zweites Metallverbindungsstück und ein Schaltelement umfasst;
eine zweite Elektrode des ersten MTJ durch Verwenden des ersten Metallverbindungsstücks mit einem ersten Ende des Schaltelements elektrisch verbunden ist;
der zweite MTJ durch Verwenden des zweiten metallischen Drahts in Reihe mit dem dritten MTJ verbunden ist;
ein erstes Ende des zweiten metallischen Drahts mit einer zweiten Elektrode des zweiten MTJ elektrisch verbunden ist, ein zweites Ende des zweiten metallischen Drahts mit einer ersten Elektrode des dritten MTJ elektrisch verbunden ist und die zweite Elektrode des zweiten MTJ und die erste Elektrode des dritten MTJ beide obere Elektroden oder untere Elektroden sind;
der dritte MTJ durch Verwenden des dritten metallischen Drahts in Reihe mit dem vierten MTJ verbunden ist;
ein erstes Ende des dritten metallischen Drahts mit einer zweiten Elektrode des dritten MTJ elektrisch verbunden ist, ein zweites Ende des dritten metallischen Drahts mit einer ersten Elektrode des vierten MTJ elektrisch verbunden ist und die zweite Elektrode des dritten MTJ und die erste Elektrode des vierten MTJ beide obere Elektroden oder untere Elektroden sind;
ein zweites Ende des Schaltelements mit einer Sourceleitung elektrisch verbunden ist; und ein Steuerende des Schaltelements mit einer Wortleitung elektrisch verbunden ist; wobei die Speicherungseinheit sechzehn Widerstandszustände aufweist; und
wobei Verbindungsleitungen zwischen einem Mittelpunkt des ersten MTJ, einem Mittelpunkt des zweiten MTJ, einem Mittelpunkt des dritten MTJ und einem Mittelpunkt des vierten MTJ ein Viereck ausbilden.

3. Speicherungseinheit nach einem der vorstehenden Ansprüche, wobei sich der erste MTJ und der zweite MTJ auf derselben Schicht einer laminierten Struktur befinden und mittels einmaliger Dünnschichtabscheidung ausgebildet werden.

4. Speicherungseinheit nach einem der Ansprüche 1 bis 3, wobei die Bitleitung parallel zu dem ersten metallischen Draht verläuft, die Bitleitung senkrecht zu der Wortleitung verläuft und die Bitleitung senkrecht zu der Sourceleitung verläuft.

5. Speicherungseinheit nach einem der Ansprüche 1 bis 3, wobei die Bitleitung senkrecht zu dem ersten metallischen Draht verläuft, die Bitleitung senkrecht zu der Wortleitung verläuft und die Bitleitung parallel zu der Sourceleitung verläuft.

6. Speicherungsarray, das eine Wortleitung, eine Bitleitung, eine Sourceleitung und mindestens eine Speicherungseinheit umfasst, wobei
die Speicherungseinheit die Speicherungseinheit nach einem der Ansprüche 1 bis 5 ist.

7. Speicher (100), der eine Speicherungseinheit (101) und eine Steuervorrichtung (102) umfasst, wobei
die Speicherungseinheit Daten unter Steuerung der Steuervorrichtung speichert und die Speicherungseinheit die Speicherungseinheit nach einem der Ansprüche 1 bis 5 ist.

8. Rechenspeicher, der eine Speicherungseinheit und eine Steuervorrichtung umfasst, wobei die Speicherungseinheit Daten speichert und/oder Daten unter Steuerung der Steuervorrichtung berechnet und die Speicherungseinheit die Speicherungseinheit nach einem der Ansprüche 1 bis 5 ist.

## Revendications

1. Unité de stockage, dans laquelle l'unité de stockage comprend une première jonction à effet tunnel magnétique, MTJ, ayant deux états de résistance, une deuxième MTJ ayant deux états de résistance, et un premier fil métallique ;
la première MTJ est connectée en série à la deuxième MTJ en utilisant le premier fil métallique ; et
une première extrémité du premier fil métallique est connectée électriquement à une première électrode de la première MTJ, une seconde extrémité du premier fil métallique est connectée électriquement à une première électrode de la deuxième MTJ, et la première électrode de la première MTJ et la première électrode de la deuxième MTJ sont toutes deux des électrodes supérieures ou des électrodes inférieures ;
dans laquelle l'unité de stockage comprend en outre une troisième MTJ, le premier fil métallique, un deuxième fil métallique, une première pièce de connexion métallique, une seconde pièce de connexion métallique, et un élément de commutation ;
une seconde électrode de la première MTJ est connectée électriquement à une première extrémité de l'élément de commutation en utilisant la première pièce de connexion métallique ;
la deuxième MTJ est connectée en série à la troisième MTJ en utilisant le deuxième fil métallique ;
une première extrémité du deuxième fil métallique est connectée électriquement à une seconde électrode de la deuxième MTJ, une seconde extrémité du deuxième fil métallique est connectée électriquement à une première électrode de la troisième MTJ, et la seconde électrode de la deuxième MTJ et la première électrode de la troisième MTJ sont toutes deux des électrodes supérieures ou des électrodes inférieures ;
une seconde électrode de la troisième MTJ est connectée électriquement à une ligne de bits en utilisant la deuxième pièce de connexion métallique ;
une seconde extrémité de l'élément de commutation est connectée électriquement à une ligne de source ; et
une extrémité de commande de l'élément de commutation est connectée électriquement à une ligne de mots ;
dans laquelle l'unité de stockage a huit états de résistance ; et
dans laquelle un angle inclus entre le premier fil métallique et le deuxième fil métallique est un angle aigu, et des lignes de connexion entre un centre de la première MTJ, un centre de la deuxième MTJ, et un centre de la troisième MTJ forment un triangle aigu.

2. Unité de stockage, dans laquelle l'unité de stockage comprend une première jonction à effet tunnel magnétique, MTJ, ayant deux états de résistance, une deuxième MTJ ayant deux états de résistance, et un premier fil métallique ;
la première MTJ est connectée en série à la deuxième MTJ en utilisant le premier fil métallique ; et
une première extrémité du premier fil métallique est connectée électriquement à une première électrode de la première MTJ, une seconde extrémité du premier fil métallique est connectée électriquement à une première électrode de la deuxième MTJ, et la première électrode de la première MTJ et la première électrode de la deuxième MTJ sont toutes deux des électrodes supérieures ou des électrodes inférieures ; dans laquelle l'unité de stockage comprend en outre un deuxième fil métallique, un troisième fil métallique, une troisième MTJ, une quatrième MTJ, une première pièce de connexion métallique, une seconde pièce de connexion métallique, et un élément de commutation ;
une seconde électrode de la première MTJ est connectée électriquement à une première extrémité de l'élément de commutation en utilisant la première pièce de connexion métallique ;
la deuxième MTJ est connectée en série à la troisième MTJ en utilisant le deuxième fil métallique ;
une première extrémité du deuxième fil métallique est connectée électriquement à une seconde électrode de la deuxième MTJ, une seconde extrémité du deuxième fil métallique est connectée électriquement à une première électrode de la troisième MTJ, et la seconde électrode de la deuxième MTJ et la première électrode de la troisième MTJ sont toutes deux des électrodes supérieures ou des électrodes inférieures ;
la troisième MTJ est connectée en série à la quatrième MTJ en utilisant le troisième fil métallique ;
une première extrémité du troisième fil métallique est connectée électriquement à une seconde électrode de la troisième MTJ, une seconde extrémité du troisième fil métallique est connectée électriquement à une première électrode de la quatrième MTJ, et la seconde électrode de la troisième MTJ et la première électrode de la quatrième MTJ sont toutes deux des électrodes supérieures ou des électrodes inférieures ;
une seconde extrémité de l'élément de commutation est connectée électriquement à une ligne de source ; et
une extrémité de commande de l'élément de commutation est connectée électriquement à une ligne de mots ;
dans laquelle l'unité de stockage a seize états de résistance ; et
dans laquelle les lignes de connexion entre un centre de la première MTJ, un centre de la deuxième MTJ, un centre de la troisième MTJ, et un centre de la quatrième MTJ forment un quadrilatère.

3. Unité de stockage selon l'une quelconque revendication précédente, dans laquelle la première MTJ et la deuxième MTJ sont situées au niveau de la même couche d'une structure stratifiée et sont formées par un seul dépôt de film mince.

4. Unité de stockage selon l'une quelconque des revendications 1 à 3, dans laquelle la ligne de bits est parallèle au premier fil métallique, la ligne de bits est perpendiculaire à la ligne de mots, et la ligne de bits est perpendiculaire à la ligne de source.

5. Unité de stockage selon l'une quelconque des revendications 1 à 3, dans laquelle la ligne de bits est perpendiculaire au premier fil métallique, la ligne de bits est perpendiculaire à la ligne de mots, et la ligne de bits est parallèle à la ligne de source.

6. Matrice de stockage, comprenant une ligne de mots, une ligne de bits, une ligne de source, et au moins une unité de stockage, dans laquelle
l'unité de stockage est l'unité de stockage selon l'une quelconque des revendications 1 à 5.

7. Mémoire (100), comprenant une unité de stockage (101) et un dispositif de commande (102), dans laquelle
l'unité de stockage stocke des données sous commande du dispositif de commande, et l'unité de stockage est l'unité de stockage selon l'une quelconque des revendications 1 à 5.

8. Mémoire de calcul, comprenant une unité de stockage et un dispositif de commande, dans laquelle
l'unité de stockage stocke des données et/ou calcule des données sous commande du dispositif de commande, et l'unité de stockage est l'unité de stockage selon l'une quelconque des revendications 1 à 5.
